# FASCICULE DE BREVET EUROPEEN

(11) **EP 2 692 031 B1**
(45) Date de publication et mention de la délivrance du brevet: **27.12.2017**
(21) Numéro de dépôt: 12713366.8
(22) Date de dépôt: 26.03.2012
(51) Int. Cl.: H01S 3/16, H01S 5/10, H01S 5/36, H01S 3/08

(54) **LASER PLASMONIQUE ET SON PROCEDE DE FABRICATION.**
PLASMONISCHER LASER UND HERSTELLUNGSVERFAHREN DAFÜR
PLASMONIC LASER AND ITS FABRICATION PROCESS

(30) Priorité: 29.03.2011 FR 1152615
(43) Date de publication de la demande: 05.02.2014
(73) Titulaire: Commissariat à l'Énergie Atomique et aux Énergies Alternatives, 75015 Paris (FR)
(72) Inventeur: CHARRA, Fabrice, F-91460 Marcoussis (FR); FIORINI, Céline, F-91400 Orsay (FR); BACHELOT, Renaud, F-10120 Saint Andre Les Vergers (FR)
(74) Mandataire: Gevers & Orès
(86) Numéro de dépôt international: PCT/IB2012/051429
(87) Numéro de publication internationale: WO 2012/131566

(56) Documents cités:
- US-A1- 2004 155 184
- FRANCISCO J. GARCIA-VIDAL ET AL: "Applied physics: Lasers go nano", NATURE, vol. 461, no. 7264, 1 janvier 2009 (2009-01-01), pages 604-605, XP055014690, ISSN: 0028-0836, DOI: 10.1038/461604a
- NOGINOV M A ET AL: "Demonstration of a spaser-based nanolaser", NATURE NATURE PUBLISHING GROUP UK, vol. 460, no. 7259, 27 août 2009 (2009-08-27), pages 1110-1112, XP002665653, ISSN: 0028-0836 cité dans la demande
- IBN-EL-AHRACH H ET AL: "Controlling the plasmon resonance of single metal nanoparticles by near-field anisotropic nanoscale photopolymerization", JOURNAL OF MICROSCOPY BLACKWELL SCIENCE LTD. UK, vol. 229, mars 2008 (2008-03), pages 421-427, XP002665710, ISSN: 0022-2720
- AHRACH H I E ET AL: "Spectral degeneracy breaking of the plasmon resonance of single metal nanoparticles by nanoscale near-field photopolymerization", PHYSICAL REVIEW LETTERS APS USA, vol. 98, no. 10, 9 mars 2007 (2007-03-09), pages 107402/1-4, XP002665711, ISSN: 0031-9007

## Description

L'invention porte sur un laser de type plasmonique, ainsi que sur son procédé de fabrication.

Un laser est constitué essentiellement d'un milieu à gain, présentant un gain optique, situé à l'intérieur d'une cavité optique. Comme dans d'autres domaines de la technique, il existe une tendance forte à la miniaturisation des lasers ; ainsi, en l'espace de cinquante ans, l'on est passé de lasers « macroscopiques » (à rubis, hélium-néon...) dont les dimensions se mesurent en dizaines de centimètres, voire en mètres, à des micro-lasers semi-conducteurs à structure monolithique, fabriqués grâces à des technologies empruntées à la micro-électronique. Cette course à la miniaturisation rencontre cependant une limite physique : en effet les dimensions de la cavité optique doivent être au moins de l'ordre de la longueur d'onde d'émission dans le matériau actif. En pratique, les cavités optiques présentent généralement des tailles de quelques micromètres ou plus.

Une possibilité pour surmonter cette limitation consiste à remplacer la cavité optique, constituée par deux miroirs planaires ou concaves piégeant des photons, par un « résonateur plasmonique » constitué par un nano-objet métallique supportant des plasmons, c'est à dire des oscillations quantifiées d'un gaz d'électrons. En effet, un plasmon peut être confiné dans un volume de dimensions très inférieures à la longueur d'onde d'un photon oscillant à la même fréquence. En 2003, D.J. Bergman et M. I. Stockman ont proposé le concept de « SPASER », c'est-à-dire d'amplification de plasmons de surface par émission stimulée de rayonnement. Un SPASER est essentiellement constitué par un « résonateur plasmonique » associé étroitement à un matériau actif pompé optiquement ; les plasmons du résonateur stimulent des transitions dipolaires électriques dans le milieu à gain, qui à leur tour excitent d'autres plasmons identiques, selon un mécanisme analogue à celui à la base du fonctionnement des lasers conventionnels. Dans certaines conditions, les modes plasmoniques confinés dans le résonateur sont couplés avec des modes optiques, ce qui fait qu'un SPASER émet de la lumière.

Le principe du SPASER est décrit dans les articles suivants :
- D. J. Bergman et M. I. Stockman « Surface Plasmon Amplification by Stimulated Emission of Radiation : Quantum Generation of Coherent Surface Plasmons in Nanosystems », Phys. Rev. Letters, Vol. 90, N°2 (2003) ;
- M. I. Stockman « Spasers Explained », Nature Photonics, Vol. 2, juin 2008, pages 327 - 329;
ainsi que dans le brevet US 7,569,188 et la demande de brevet US 2004/0155184A1. Le premier nano-laser basé sur le principe du SPASER a été décrit dans l'article de M. A. Noginov et al. « Demonstration of a spaser-based nano-laser », Nature, Vol. 460, pages 1110 - 1112, 27 août 2009. Ce dispositif est constitué d'une nanoparticule sphérique de 44 nm de diamètre comprenant un coeur en or d'un diamètre de 14 nm (résonateur plasmonique), entouré par une coquille en silice de 15 nm d'épaisseur, dopée par un colorant (milieu à gain). Il s'agit du plus petit laser réalisé à ce jour. Le principal inconvénient de ce dispositif est son caractère fortement multi-mode. En effet, la nanoparticule métallique supporte un nombre important de modes plasmoniques qui présentent des fréquences très proches, voire identiques (modes dits dégénérés), et sont par conséquent susceptibles d'interagir avec le milieu à gain. Il en résulte un seuil d'effet laser relativement élevé, car l'énergie de pompage se repartit uniformément entre les différents modes, ce qui induit un échauffement important ; une polarisation non maîtrisée ; et surtout une absence de cohérence spatiale qui empêche la collimation de la lumière émise par des éléments optiques conventionnels.

L'article de N. I. Zheludev et al. « Lasing spaser », Nature Photonics, Vol. 2, juin 2008, pages 351 - 329 propose une source de lumière cohérente formée par un réseau planaire de SPASERs. Bien que chaque SPASER, considéré individuellement, soit de dimensions nanométriques, la source dans son ensemble constitue un dispositif macroscopique.

L'article de R. F. Oulton et al. « Plasmon laser at deep subwavelength scale », Nature, Vol. 461, pages 629 -632, 1er octobre 2009, décrit un laser plasmonique formé par un nanofil en CdS séparé d'une surface d'argent par une couche diélectrique de 5 nm d'épaisseur. Le nanofil est pompé optiquement pour servir de milieu à gain ; un effet de guidage par le gain permet de confiner des modes plasmoniques de surface dans la région immédiatement au-dessous dudit nanofil. Un tel dispositif présente des dimensions plus importantes que le nano-laser précité de M. A. Noginov et al. ; en outre, son émission demeure multimodale.

L'invention vise à résoudre les inconvénients de l'art antérieur, en procurant un laser plasmonique de dimensions nanométriques susceptible d'osciller sur un seul mode. Conformément à l'invention, un tel but peut être atteint par un laser plasmonique comprenant une nanostructure métallique supportant une pluralité (deux ou plus) de modes plasmoniques (« résonateur plasmonique ») ; et un milieu à gain présentant un gain optique à la fréquence d'oscillation d'au moins un dit mode plasmonique, couplé en champ optique proche avec ladite nanostructure ; caractérisé en ce que ledit milieu à gain est structuré de manière à présenter une forme qui épouse la distribution spatiale d'intensité d'un dit mode plasmonique, à la fréquence duquel ledit milieu à gain présente un gain optique. De cette manière, un seul mode plasmonique présente un bon recouvrement avec le milieu à gain et, de ce fait, est amplifié de manière suffisante pour compenser les pertes et entretenir une oscillation de type SPASER. En outre, l'énergie déposée (généralement par pompage optique) dans le milieu à gain est exploitée efficacement, réduisant le seuil et minimisant la production de chaleur.

Dans le nano-laser de M. A. Noginov et al., au contraire, le milieu à gain est disposé de manière uniforme autour d'un oscillateur plasmonique sphérique : aucun mode n'est donc privilégié par rapport aux autres. Le laser plasmonique de R. F. Oulton et al. présente une distribution non-uniforme du milieu à gain (le nanofil en CdS) ; mais cette distribution est définie a priori par des considérations technologiques, et n'épouse pas un mode du résonateur plasmonique.

Par « nanostructure » on entend une structure dont au moins une - et de préférence au moins deux - de ses trois dimensions principales (hauteur, largeur, longueur) est inférieure ou égale à 100 nm ; de préférence, la troisième dimension doit être inférieure ou égale à 1 µm. Ainsi, constituent des nanostructures des nanofils (diamètre de quelques dizaines de nanomètres, voire de quelques nanomètre ; longueur de 100 nm à quelques micromètres), des nanoparticules sphériques (diamètre de quelques dizaine de nanomètres, voire de quelques nanomètre), ellipsoïdales ou en bâtonnet (axes principaux de quelques dizaines de nanomètres, voire de quelques nanomètre). Des couches étendues, dont seule l'épaisseur est de taille nanométrique, ne sont généralement pas considérées comme étant des nanostructures, sauf si elles sont structurées de manière à présenter des détails de dimensions caractéristiques inférieures ou égale à 100 nm et de préférence inférieures ou égales à 10 nm. Afin d'épouser la distribution spatiale d'intensité d'un mode plasmonique, le matériau à gain d'un laser selon l'invention doit généralement être structuré à l'échelle nanométrique. On entend par « structuré à l'échelle nanométrique » un objet de forme complexe (c'est-à-dire ne correspondant pas à un solide simple : sphère, cylindre, ellipsoïde, parallélépipède...) présentant des détails de dimensions caractéristiques inférieures ou égale à 100 nm et de préférence inférieures ou égales à 10 nm.

On entend par « nanostructure métallique » une nanostructure présentant des propriétés, notamment électriques et/ou optiques, de type métallique. Elle peut notamment comprendre un métal au sens chimique, ou bien d'un semi-conducteur (inorganique tel que le silicium, ou organique, tel qu'un polymère conjugué) dégénéré c'est à dire fortement dopé N ou P pour donner une conduction électrique de type métallique, ou bien d'un nanotube de carbone présentant des propriétés métalliques.

Le milieu à gain peut être chimiquement homogène ou hétérogène. En particulier, il peut comporter une matrice inerte, transparente, et un dopant luminescent, responsable du gain optique.

En disant que le milieu à gain « épouse » la distribution spatiale d'intensité d'un mode plasmonique on entend que l'espace occupé par le milieu à gain est limité par une surface qui correspond sensiblement à une surface isométrique de la surface définie par le profil dudit mode.

Avantageusement, cette surface peut être choisie de façon à maximiser la différence entre l'intégral de recouvrement du milieu à gain avec le mode sélectionné et l'intégral de recouvrement dudit milieu avec les autres modes du résonateur plasmonique. Par exemple, l'intégrale de recouvrement du milieu à gain avec le mode plasmonique sélectionné peut prendre une valeur de 30% ou plus, et de préférence de 50% ou plus tandis que l'intégral de recouvrement dudit milieu à gain avec les autres modes plasmoniques peut avoir une valeur de 20% ou moins.

Il convient de noter que les modes plasmoniques confinés dans un volume de dimensions nanométriques présentent généralement une géométrie complexe ce qui fait que la distinction entre « modes longitudinaux » et « modes transversaux », importante dans le cas des résonateurs optiques classiques, n'est pas appropriée.

Selon différents modes de réalisation du laser plasmonique de l'invention :
- Ladite nanostructure métallique peut être choisie parmi une nanoparticule et un nanofil.
- Ledit milieu à gain peut entourer ou recouvrir au moins en partie, et de préférence en totalité, ladite nanostructure métallique.
- Ledit milieu à gain peut être constitué par un polymère dopé avec un colorant, organique et/ou inorganique, ledit colorant étant responsable de son gain optique.
- Ladite nanostructure métallique et ledit milieu à gain peuvent être déposés sur un substrat. En variante, ladite nanostructure métallique et ledit milieu à gain peuvent être placés dans une matrice solide transparente à la fréquence d'oscillation dudit mode plasmonique.

Un autre objet de l'invention est un procédé de fabrication d'un tel dispositif, qui présente l'avantage d'être simple et peu couteux. Ce procédé comprend les étapes consistant à :
- mettre une nanostructure métallique, supportant une pluralité de modes plasmoniques, en contact avec un milieu pouvant être insolé par un rayonnement à la longueur d'onde d'au moins un dit mode plasmonique ; et
- exciter sélectivement ledit mode plasmonique de la nanostructure métallique, de manière à insoler localement ledit milieu, moyennant quoi l'on obtient une matrice structurée, recouvrant au moins en partie ladite nanostructure métallique et dont la forme épouse la distribution spatiale d'intensité dudit mode plasmonique.

En d'autres termes, c'est le mode plasmonique lui-même qui « met en forme » le milieu à gain destiné à l'amplifier. On obtient ainsi, de manière automatique, une très bonne correspondance entre la forme du milieu à gain et la distribution spatiale d'intensité du mode que l'on veut sélectionner. Obtenir une telle correspondance en façonnant directement un bloc de milieu à gain, par exemple par des techniques de lithographie ultraviolette ou électronique, serait extrêmement difficile et pas économiquement viable.

Le procédé de l'invention s'inspire d'une technique mise à point par C. Deeb et al. afin d'étudier la distribution spatiale des modes plasmoniques d'un nano-objet. Dans cette technique, la photo-polymérisation est utilisée pour créer une « empreinte » tridimensionnelle en résine d'un mode plasmonique, cette empreinte pouvant ensuite être observée par microscopie à force atomique. Voir à ce propos :
- C. Deeb « Optical Properties of Metal Nanostructures as Probed by Photosensitive Molecules », Thèse de doctorat de l'Université Technologique de Troyes, Septembre 2010 ;
- C. Deeb et al. « Off-Resonant Optical Excitation of Gold Nanorods : Nanoscale Imprint of Polarization Surface Charge Distribution », J. Phys. Chem. Lett. 2011, 2, page 7 - 11, publié sur Internet le 10 décembre 2010.

Il importe de noter que ces documents ne font pas état de l'excitation d'un mode plasmonique unique. En outre, il n'est pas question de fabriquer un quelconque dispositif, mais seulement de permettre une visualisation indirecte de la distribution de charges à la surface d'un nano-objet.

Selon différents modes de réalisation du procédé de l'invention :
- Ledit milieu pouvant être insolé peut être un liquide photo-polymérisable.
- Ledit milieu pouvant être insolé peut contenir un élément actif présentant une émission fluorescente dont le spectre inclut la fréquence d'oscillation dudit mode plasmonique dans ladite matrice.
- En variante, ledit procédé peut comprendre également une étape ultérieure d'introduction d'un élément actif, tel qu'un colorant, présentant une émission fluorescente dont le spectre inclut la fréquence d'oscillation dudit mode plasmonique dans ladite matrice.
- Ledit milieu pouvant être insolé peut contenir un photo-sensibilisateur rendant possible son insolation par exposition à un rayonnement électromagnétique à la fréquence dudit mode plasmonique. Dans ce cas, une étape de photo-blanchiment peut avantageusement être prévue pour désactiver ledit photo-sensibilisateur contenu dans ladite matrice.

D'autres caractéristiques, détails et avantages de l'invention ressortiront à la lecture de la description faite en référence aux dessins annexés donnés à titre d'exemple et qui montrent, respectivement :
- la figure 1, une représentation schématique d'un laser plasmonique selon un mode de réalisation de l'invention ;
- les figures 2A - 2F, une représentation schématique des différentes étapes d'un procédé de fabrication du dispositif de la figure 1 ;
- Les figures 3A - 3C, 4A - 4C et 5 ; différentes techniques d'excitation sélective d'un mode plasmonique d'une nanostructure métallique, pouvant être utilisées pour la fabrication d'un laser plasmonique selon un mode de réalisation de l'invention.

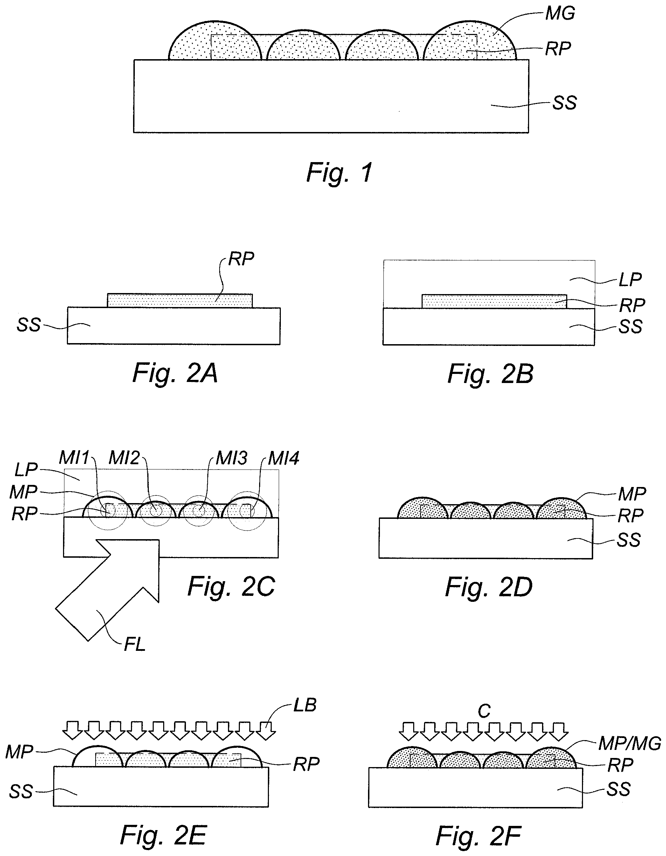

Le laser plasmonique de la figure 1 comprend essentiellement un résonateur plasmonique RP, sous la forme d'un nanofil en or, déposé sur un substrat SS en verre et entouré par un milieu actif, ou milieu à gain, MG.

Le nanofil RP est constitué par un bâtonnet en argent ou en or dont la longueur est de quelques centaines de nanomètres (100 - 300 nm) et les dimensions transversales - largeur et épaisseur - de quelques dizaines de nanomètres.

Le milieu à gain MG entoure le résonateur plasmonique sur toute sa surface libre (c'est-à-dire à l'exclusion de la surface de contact avec le substrat), mais dans d'autres modes de réalisation il pourrait le recouvrir seulement en partie. Ce milieu est solide, constitué essentiellement par une résine pouvant être obtenue par photo-polymérisation d'un précurseur et formant une matrice transparente à la longueur d'onde d'émission du laser, et d'un dopant fluorescent (ex. colorant organique, colorant organique-inorganique ou inorganique comme les boîtes quantiques) émettant à ladite longueur d'onde ; il peut s'agir par exemple de fluorescéine, émettant dans le vert, à 530 - 550 nm. Le précurseur peut être par exemple du pentaerythritol triacrylate (PETIA).

Comme expliqué plus haut, le milieu à gain présente une forme complexe, qui correspond essentiellement à la distribution spatiale d'intensité d'un mode plasmonique du nanofil RP, dont la fréquence de résonance est située dans la bande d'émission du dopant luminescent. Dans l'exemple considéré ici, ce mode présente une pluralité de maxima locaux d'intensité alignés le long de la direction principale (longueur) du nanofil ; ces maxima locaux se traduisent en protubérances en forme de « billes » ou « boules » du milieu à gain.

On remarquera que, tandis que dans un laser conventionnel le milieu à gain est placé à l'intérieur d'un résonateur optique, dans le laser plasmonique de la figure 1 c'est le résonateur plasmonique qui est entouré par le milieu à gain.

Pour obtenir l'émission d'un rayonnement laser, on éclaire le milieu à gain avec un rayonnement dont la longueur d'onde λ_{inc} se situe dans la bande d'absorption de ce milieu (le cas échéant : du dopant fluorescent de ce milieu), qui est décalée vers le bleu par rapport à son spectre d'émission λ_{flu} ; dans le cas considéré ici, où le milieu à gain est une matrice passive dopée par de la fluorescéine, le pompage peut se faire dans le bleu, à 490 - 500 nm. L'excitation du milieu à gain est transférée de manière non-radiative aux modes plasmoniques du nanofil dont l'énergie (et donc la fréquence optique, νₚₗₐₛ à laquelle on peut associer une longueur d'onde « équivalente » λₚₗₐₛ=c/νₚₗₐₛ=λ_{flu}) est située dans la bande d'émission du milieu ; le mode plasmonique s'étend très peu au-delà du nanofil, par conséquent ce dernier et le milieu à gain doivent être en contact l'un avec l'autre, ou en tout cas très proches entre eux (couplage en champ proche optique, typiquement à une distance non supérieure à 100 nm). A leur tour, les plasmons provoquent la désexcitation du milieu à gain par émission stimulée, ce qui provoque la génération d'autres plasmons identiques. Comme expliqué plus haut, à cause de la nano-structuration du milieu à gain, un seul mode plasmonique présente un recouvrement avec le profil spatial du gain optique (déterminé par la géométrie dudit milieu à gain) suffisant pour qu'une oscillation de type SPASER puisse s'entretenir. On obtient donc une oscillation plasmonique monomodale ; ce mode plasmonique est naturellement couplé avec des modes photoniques (c'est-à-dire des ondes électromagnétiques présentant un vecteur d'onde réel), par conséquent la structure émet un rayonnement qui présente une bonne cohérence spatiale et temporelle. Etant donné que la source présente des dimensions très inférieures à λ (longueur d'onde dans le vide du rayonnement émis), l'émission est omnidirectionnelle ; toutefois, en raison de sa cohérence spatiale elle peut être convertie en un faisceau collimaté au moyen d'éléments optiques conventionnels (lentilles, miroirs...).

Les figures 2A - 2F illustrent les différentes étapes d'un procédé de fabrication d'un laser plasmonique selon l'invention.

La figure 2A montre le substrat SS avec le résonateur plasmonique RP, réalisé par exemple par lithographie électronique à partir d'une couche d'or déposée sur ledit substrat.

Sur la figure 2B on peut voir que le résonateur plasmonique et le substrat, ou au moins la portion de la surface supérieure du substrat à proximité immédiate dudit résonateur, sont immergés dans un liquide photo-polymérisable LP. Ce liquide peut comprendre en particulier trois composants : un colorant photo-sensibilisant, un co-synergiste et un monomère. Par exemple, le colorant photo-sensibilisant peut être de l'éosine Y (2',4',5',7'-tétrabromofluorescéine disodique) présentant une bande d'absorption à 450 - 550 nm, à une concentration de 0,5% en poids; le co-synergiste, une amine telle que la méthyldiethanolamine (MDEA) à une concentration de 4% en poids et le monomère du pentaerythritol triacrylate (PETIA).

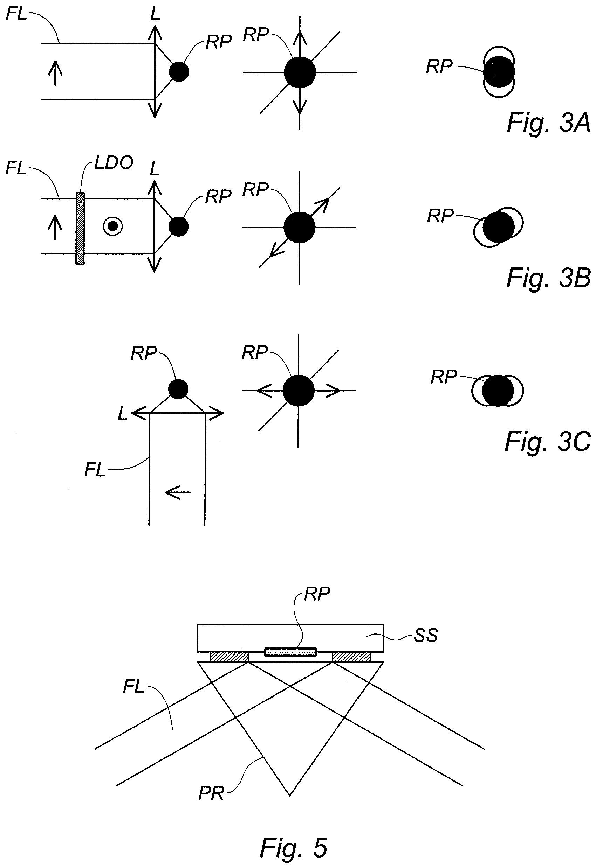

La figure 2C montre l'étape consistant à éclairer le résonateur plasmonique par un faisceau laser FL (plus généralement : un rayonnement électromagnétique cohérent) dont la fréquence optique, l'angle d'incidence, la polarisation et la distribution spatiale sont choisis de manière à exciter de manière préférentielle un mode plasmonique du résonateur RP ; différentes techniques pour réaliser une telle excitation sélective seront décrites plus loin en référence aux figures 3A - 3C, 4A - 4C et 5. Le liquide photo-polymérisable est sensible au rayonnement électromagnétique à la fréquence optique du faisceau FL (par exemple, 530 nm), et donc du mode plasmonique excité par ce dernier. Plus précisément les molécules d'éosine, excitées par les photons incidents, subissent une photoréduction avec la MDEA comme donneur d'électron. Puis, les radicaux libres amines ainsi obtenus initient la réticulation du PETIA qui, à lui seul, n'absorbe pas la lumière à la longueur d'onde du faisceau FL. Toutefois, la dose délivrée par le faisceau FL est inférieure au seuil de réticulation de ce liquide (par exemple : 65% de cette dose). A proximité du nanofil RP, le rayonnement incident FL s'additionne, de manière cohérente, avec celui généré par le mode plasmonique ; localement, le seuil de réticulation est donc dépassé. De cette manière, la photo-polymérisation du liquide LP se produit uniquement en correspondance des maxima locaux d'intensité du mode plasmonique excité, indiqués schématiquement par MI1 - MI4 sur la figure. Il s'agit de l'effet exploité par C. Deeb et al. pour étudier la distribution de charge de surface dans des nano-objets.

On obtient ainsi une matrice polymérique MP entourant le nanofil RP, réalisé en matériau polymérique et dont la forme épouse celle d'un mode plasmonique de ce dernier. Le liquide non polymérisé est éliminé par rinçage (figure 2D). Puis, l'on expose la matrice MP à une lumière intense LB pour désactiver (« blanchir ») le photosensibilisateur (éosine) susceptible d'absorber la lumière à la fréquence optique du mode plasmonique sélectionné. En effet, cette absorption est nécessaire pour permettre la constitution de la matrice polymérique, mais ne doit pas subsister dans le dispositif complet, car elle réduirait l'efficacité d'émission lumineuse. Cette étape de « photoblanchiment » est illustrée schématiquement sur la figure 2E.

Enfin, comme illustré sur la figure 2F, un colorant C est introduit par diffusion dans la matrice polymérique MP pour en faire un milieu à gain MG, présentant un gain optique. Dans l'exemple considéré ici, on peut utiliser la fluorescéine qui absorbe une lumière bleue (λ_{abs}=490-500 nm) et présente une bande d'émission dans le vert (λ_{flu}=530-550 nm) comprenant à son intérieur la « longueur d'onde efficace » du mode plasmonique sélectionné (λₚₗₐₛ) qui, par construction, est égale à la longueur d'onde du faisceau FL (λ_{FP}=λₚₗₐₛ=530 nm).

L'étape 2C d'excitation sélective d'un mode plasmonique de la nanostructure métallique RP constitue un aspect important de l'invention. Elle peut être réalisée de plusieurs manières différentes, dont certaines sont illustrées à titre d'exemple sur les figures 3A - 3C, 4A - 4C et 5. Dans tous les cas considérés ici, il s'agit d'illuminer la nanostructure avec un rayonnement laser dont la fréquence (longueur d'onde), la polarisation, la direction de propagation et la distribution angulaire de rayonnement sont choisis de manière à s'approcher au mieux des paramètres du rayonnement correspondant au mode sélectionné.

Le paramètre le plus important, car le plus sélectif, est constitué par la fréquence, ou longueur d'onde, du rayonnement, qui peut être choisie en accordant la source laser d'éclairage ou par filtrage. Cette fréquence correspond à celle d'émission du nano-laser à fabriquer et détermine le choix du colorant et du photo-sensibilisateur.

La polarisation du faisceau laser peut être ajustée grâce à des lames à demi-onde, pour un laser polarisé linéairement.

La direction et le diagramme angulaire du faisceau sont déterminés, d'une manière conventionnelle en soi, par des éléments optiques tels que des miroirs et/ou des lentilles.

A titre d'exemple, les figures 3A à 3C illustrent l'excitation sélective d'un mode dipolaire d'une nanoparticule sphérique RP, orienté selon la direction x, y ou z, respectivement. Le diagramme d'émission du mode présente deux lobes opposés, en phase entre eux ; un tel diagramme peut être reproduit simplement en focalisant le faisceau laser FL sur la nanoparticule RP au moyen d'une lentille L. Le cas échéant, la polarisation du faisceau est tournée au moyen d'une lame à demi-onde LDO orientée à 45° (c'est-à-dire dont l'axe optique forme un angle de 45° avec la direction de polarisation linéaire du faisceau incident). Dans chacune de ces figures, la partie de gauche montre le montage optique d'excitation sélective d'un mode plasmonique ; la partie centrale, la polarisation dudit mode ; et la partie de droite son diagramme de rayonnement.

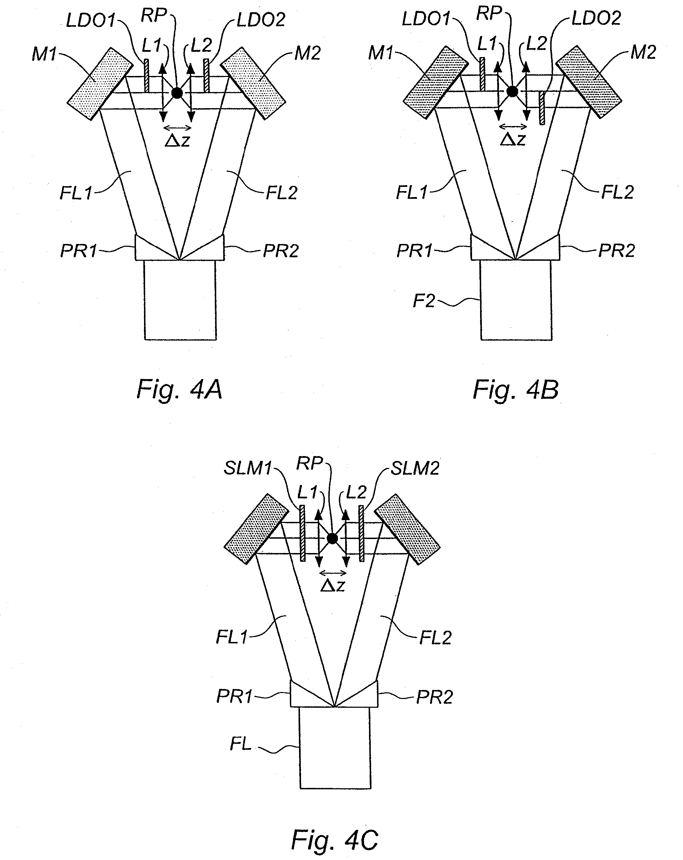

L'excitation d'un mode quadripolaire de la même nanoparticule sphérique requiert deux faisceaux lasers cohérents entre eux et se propageant dans des directions opposées, avec des phases différentes, pour former les quatre lobes du diagramme de rayonnement caractérisant un tel mode. Dans le cas des figures 4A et 4B, les deux faisceaux FL1, FL2 sont formés à partir d'un faisceau unique FL en utilisant un double prisme PR1, PR2. Leur orientation est modifiée par deux miroirs M1, M2. Deux lames à demi-onde orientées à 0°, LDO1 et LDO2, introduisent un déphasage de 180° (π rad) sur une moitié de la section de chaque faisceau. Comme dans le cas de l'excitation d'un mode dipolaire, les faisceaux sont focalisés sur la nanoparticule RP à l'aide de lentilles respectives, L1 et L2.

La phase relative des deux faisceaux est importante : elle devra être nulle (faisceaux en phase) dans l'exemple choisi. Cela pourra être ajusté par un déplacement micrométrique Δz le long de la direction de propagation, comme indiqué sur les figures. Si plusieurs lasers plasmoniques doivent être fabriqués simultanément, ils devront être placés dans un même plan perpendiculaire à z. Ce sera le cas par exemple avec des nano-objets obtenus par lithographie sur un substrat.

Les montages des figures 4A et 4B se distinguent seulement par l'agencement des lames à demi-onde ; ils conduisent à l'excitation d'un mode quadripolaire avec m=0 et m=±1, respectivement.

La figure 4C illustre un montage plus flexible, dans laquelle les lames à demi-onde sont remplacées par des modulateurs spatiaux programmables SLM1, SLM2.

Pour des nanoparticules non sphériques, par exemple des nanofils ou des bâtonnets, il peut être avantageux de moduler spatialement la phase de l'onde excitatrice. Cela peut être obtenu, par exemple, à l'aide d'un prisme PR en configuration de « réflexion totale atténuée », comme représenté sur la figure 5. Dans cet exemple, la nanoparticule RP en forme de bâtonnet, sur son substrat, est séparée du prisme RP par des cales mécaniques dont l'épaisseur est de l'ordre de la distance d'atténuation de l'onde évanescence, c'est-à-dire de la longueur d'onde optique. On reconnaitra une configuration d'excitation de plasmons de surface de type « Otto ».

Plusieurs variantes du dispositif et du procédé de fabrication peuvent être envisagées sans sortir du cadre de l'invention. Notamment :
- Comme alternative à la lithographie électronique, les nano-objets métalliques servant de résonateurs plasmoniques peuvent être déposés à partir d'une suspension colloïdale, ou bien synthétisés sur la surface fonctionnalisée du substrat ; ces techniques sont connues par elles-mêmes. Ces nano-objets peuvent présenter une forme allongée, en bâtonnet ou nano-fil, ou plus compacte (sphérique, ellipsoïdale...). Comme expliqué plus haut, ils peuvent être constitués d'un métal au sens chimique, et plus particulièrement un métal noble tel que l'or ou l'argent, ou bien d'un semi-conducteur dopé, ou même de carbone. Leur composition peut être homogène ou hétérogène.
- D'autres photosensibilisateurs que l'éosine Y peuvent être utilisés ; par exemple, le bleu de méthylène permet d'utiliser un faisceau excitateur FL dans le rouge.
- D'autres compositions de précurseurs, exploitant différents mécanismes d'insolation, peuvent être utilisées. A titre d'exemples non limitatifs on peut envisager, outre la photo-polymérisation de monomères, éventuellement en présence d'un photosensibilisateur (cas considéré jusqu'ici) :
- l'utilisation de matériaux hybrides sol-gel, par exemple des siloxanes obtenus à partir du précurseur méthacryloxypropyltriméthoxysilane ;
- l'utilisation de polymères et résines photoréticulables qui deviennent insolubles après réticulation induite par l'insolation. C'est notamment le cas des résines de photolithographie (dites « positives »). La différence par rapport aux autres cas considérés ici est que le milieu initial n'est pas liquide mais solide.
- L'insolation peut se faire par absorption multiphotonique, voire de manière indirecte par effet des photoélectrons émis localement par la nanostructure métallique excitée par le mode plasmonique ; voir à ce propos l'article de T. Yokoyama « Plasmon-Enhanced Photopolymerization of SU-8 on Rough Gold Surfaces », J. Phys. Chem. C, 2010, 114 (46), pp 19596-19599. Ces variantes permettent d'éviter l'utilisation d'un photosensibilisateur.
- Au lieu d'immerger l'ensemble nano-objet/substrat dans le liquide polymérisable, on peut se limiter à déposer une goutte de ce liquide sur la surface du substrat, en correspondance du nano-objet. Plus généralement, on peut amener le nano-objet formant résonateur plasmonique en contact avec le précurseur du milieu à gain - ou de la matrice passive dudit milieu à gain, que ce précurseur soit liquide ou solide.
- L'étape de photoblanchiment peut être omise, si les pertes provoquées par le photosensibilsateur sont tolérables, ou bien si aucun photosensibilsateur n'est utilisé.
- D'autres dopants luminescents peuvent être utilisés, en fonction de la longueur d'onde d'émission souhaitée. Parmi les colorants organiques on peut mentionner le bleu de méthylène, absorbant et émettant dans le rouge. On peut aussi utiliser des boîtes quantiques.
- Au lieu d'être introduit dans la matrice à l'étape 2F, le dopant luminescent peut être inclus dès le départ dans le liquide photo-polymérisable. Dans ce cas, il faudra veiller à ce que les différentes étapes du procédé ne dégradent pas ses propriétés.
- Il est également possible de prévoir une préparation de précurseurs qui, insolés, forment un polymère fluorescent, et en particulier un polymère conjugué. Dans ce cas, la matrice elle-même est fluorescente, sans besoin de dopage.
- Au lieu d'être déposé sur un substrat, ou en complément, le nano-laser peut être inclus dans une matrice solide, transparente à la fréquence d'oscillation du mode plasmonique (et, le cas échéant, à la fréquence optique du rayonnement de pompage).
- Le laser plasmonique de l'invention peut être pompé électriquement, en particulier si la matrice du milieu à gain est constituée d'un polymère conjugué semi-conducteur.

## Revendications

1. Laser plasmonique comprenant :
- une nanostructure métallique (RP) supportant une pluralité de modes plasmoniques ; et
- un milieu à gain (MG) présentant un gain optique à la fréquence d'oscillation d'au moins un dit mode plasmonique, couplé en champ optique proche avec ladite nanostructure ;
**caractérisé en ce que** ledit milieu à gain est structuré de manière à présenter une forme qui épouse la distribution spatiale d'intensité d'un dit mode plasmonique, à la fréquence duquel ledit milieu à gain présente un gain optique.

2. Laser plasmonique selon la revendication 1 dans lequel ladite nanostructure métallique est choisie parmi une nanoparticule et un nanofil.

3. Laser plasmonique selon l'une des revendications précédentes, dans lequel ledit milieu à gain recouvre au moins en partie ladite nanostructure métallique.

4. Laser plasmonique selon l'une des revendications précédentes, dans lequel ledit milieu à gain est constitué par un polymère dopé avec un colorant (C), ledit colorant étant responsable de son gain optique.

5. Laser plasmonique selon l'une des revendications précédentes, dans lequel ladite nanostructure métallique et ledit milieu à gain sont déposés sur un substrat (SS).

6. Laser plasmonique selon l'une des revendications 1 à 4, dans lequel ladite nanostructure métallique et ledit milieu à gain sont placés dans une matrice solide transparente à la fréquence d'oscillation dudit mode plasmonique.

7. Procédé de fabrication d'un laser plasmonique selon l'une des revendications précédentes, comprenant les étapes consistant à :
- mettre une nanostructure métallique (RP), supportant une pluralité de modes plasmoniques, en contact avec un milieu pouvant être insolé par un rayonnement à la longueur d'onde d'au moins un dit mode plasmonique ; et
- exciter sélectivement ledit mode plasmonique de la nanostructure métallique, de manière à insoler localement ledit milieu, moyennant quoi l'on obtient une matrice structurée (MP), recouvrant au moins en partie ladite nanostructure métallique et dont la forme épouse la distribution spatiale d'intensité dudit mode plasmonique.

8. Procédé selon la revendication 7, dans lequel ledit milieu pouvant être insolé est un liquide photo-polymérisable.

9. Procédé selon l'une des revendications 7 ou 8 dans lequel ledit milieu pouvant être insolé contient un photo-sensibilisateur rendant possible son insolation par exposition à un rayonnement électromagnétique à la fréquence dudit mode plasmonique

10. Procédé selon l'une des revendications 7 à 9, comprenant également une étape d'introduction d'un élément actif dont le spectre inclut la fréquence d'oscillation dudit mode plasmonique dans ladite matrice.

11. Procédé selon l'une des revendications 7 à 10, dans lequel ledit milieu pouvant être insolé contient un photo-sensibilisateur rendant possible son insolation par exposition à un rayonnement électromagnétique à la fréquence dudit mode plasmonique.

12. Procédé selon la revendication 11, comprenant également une étape de photo-blanchiment pour désactiver ledit photo-sensibilisateur contenu dans ladite matrice polymérique.

## Patentansprüche

1. Plasmonischer Laser, umfassend:
- eine metallische Nanostruktur (RP), die eine Vielzahl plasmonischer Modi unterstützt, und
- ein Verstärkungsmedium (MG), das eine optische Verstärkung bei Oszillationsfrequenz mindestens eines plasmonischen Modus aufweist, gekoppelt im nahen optischen Feld mit der Nanostruktur,
**dadurch gekennzeichnet, dass** das Verstärkungsmedium derart strukturiert ist, dass es eine Form aufweist, die die räumliche Intensitätsverteilung eines plasmonischen Modus annimmt, bei dessen Frequenz das Verstärkungsmedium eine optische Verstärkung aufweist.

2. Plasmonischer Laser nach Anspruch 1, wobei die metallische Nanostruktur aus einem Nanopartikel und einem Nanodraht ausgewählt ist.

3. Plasmonischer Laser nach einem der vorangehenden Ansprüche, wobei das Verstärkungsmedium die metallische Nanostruktur mindestens teilweise bedeckt.

4. Plasmonischer Laser nach einem der vorangehenden Ansprüche, wobei das Verstärkungsmedium von einem mit einem Farbstoff (C) dotierten Polymer gebildet ist, wobei der Farbstoff für seine optische Verstärkung zuständig ist.

5. Plasmonischer Laser nach einem der vorangehenden Ansprüche, wobei die metallische Nanostruktur und das Verstärkungsmedium auf einem Substrat (SS) angeordnet sind.

6. Plasmonischer Laser nach einem der Ansprüche 1 bis 4, wobei die metallische Nanostruktur und das Verstärkungsmedium in einer soliden Matrix platziert sind, die bei Oszillationsfrequenz des plasmonischen Modus transparent ist.

7. Verfahren zur Herstellung eines plasmonischen Lasers nach einem der vorangehenden Ansprüche, das die folgenden Schritte umfasst:
- Inkontaktversetzen einer metallischen Nanostruktur (RP), die eine Vielzahl plasmonischer Modi unterstützt, mit einem Medium, das durch eine Strahlung in der Wellenlänge mindestens eines plasmonischen Modus bestrahlbar ist, und
- selektives Erregen des plasmonischen Modus der metallischen Nanostruktur derart, dass das Medium lokal bestrahlt wird, wodurch man eine strukturierte Matrix (MP) erhält, die die metallische Nanostruktur mindestens teilweise bedeckt und deren Form die räumliche Intensitätsverteilung des plasmonischen Modus annimmt.

8. Verfahren nach Anspruch 7, wobei das bestrahlbare Medium eine photopolymerisierbare Flüssigkeit ist.

9. Verfahren nach einem der Ansprüche 7 oder 8, wobei das bestrahlbare Medium einen Photosensibilisator enthält, der seine Bestrahlbarkeit durch Exposition gegenüber einer elektromagnetischen Strahlung in der Frequenz des plasmonischen Modus ermöglicht.

10. Verfahren nach einem der Ansprüche 7 bis 9, umfassend ebenfalls einen Einführungsschritt eines aktiven Elements, dessen Spektrum die Oszillationsfrequenz des plasmonischen Modus in der Matrix einschließt.

11. Verfahren nach einem der Ansprüche 7 bis 10, wobei das bestrahlbare Medium einen Photosensibilisator enthält, der seine Bestrahlbarkeit durch Exposition gegenüber einer elektromagnetischen Strahlung in der Frequenz des plasmonischen Modus ermöglicht.

12. Verfahren nach Anspruch 11, das ebenfalls einen Schritt der Photobleichung umfasst, um den in der Polymermatrix enthaltenen Photosensibilisator zu deaktivieren.

## Claims

1. A plasmonic laser comprising:
- a metal nanostructure (RP) supporting a plurality of plasmonic modes; and
- a gain medium (MG) having an optical gain at the oscillation frequency of at least one said plasmonic mode, coupled in near optical field with said nanostructures;
**characterized in that** said gain medium is structured so as to have a shape that marries the spatial intensity distribution of one said plasmonic modes, at the frequency of which said gain medium has an optical gain.

2. The plasmonic laser according to claim 1, wherein said metal nanostructure is chosen from among a nanoparticle and a nanowire.

3. The plasmonic laser according to one of the preceding claims, wherein said gain medium at least partially covers said metal nanostructure.

4. The plasmonic laser according to one of the preceding claims, wherein said gain medium is made up of a polymer doped with a dye (C), said dye being responsible for its optical gain.

5. The plasmonic laser according to one of the preceding claims, wherein said metal nanostructure and said gain medium are deposited on a substrate (SS).

6. The plasmonic laser according to one of claims 1 to 4, wherein said metal nanostructure and said gain medium are placed in a solid matrix transparent at the oscillation frequency of said plasmonic mode.

7. A method for fabricating a plasmonic laser according to one of the preceding claims, comprising the following steps:
- placing a metal nanostructure (RP), supporting a plurality of plasmonic modes, in contact with a medium that may be exposed to radiation at the wavelength of at least one said plasmonic mode; and
- selectively exciting said plasmonic mode of the metal nanostructure, so as to expose said medium locally, in return for which a structured matrix (MP) is obtained, at least partly covering said metal nanostructure and the shape of which marries the spatial intensity distribution of said plasmonic mode.

8. The method according to claim 7, wherein said medium able to be exposed is a photo-polymerizable liquid.

9. The method according to one of claims 7 or 8, wherein said medium that can be exposed contains a photosensitizer allowing it to be exposed by exposure to an electromagnetic radiation at the frequency of said plasmonic mode.

10. The method according to one of claims 7 to 9, also comprising a step for introducing an active element whereof the spectrum includes the oscillation frequency of said plasmonic mode in said matrix.

11. The method according to one of claims 7 to 10, wherein said medium that is able to be exposed contains a photosensitizer making its exposure possible by exposing it to electromagnetic radiation at the frequency of said plasmonic mode.

12. The method according to claim 11, also comprising a photo-bleaching step to deactivate said photosensitizer contained in said polymer matrix.
